# EUROPEAN PATENT SPECIFICATION

(11) **EP 2 457 670 B1**
(45) Date of publication and mention of the grant of the patent: **21.06.2017**
(21) Application number: 10193177.2
(22) Date of filing: 30.11.2010
(51) Int. Cl.: B05D 5/08, B05D 7/24

(54) **Method and apparatus for plasma induced coating at low pressure**
Verfahren und Vorrichtung zur plasmainduzierten Beschichtung bei niedrigem Druck
Procédé et appareil pour revêtement induit par plasma à basse pression

(43) Date of publication of application: 30.05.2012
(73) Proprietor: Oticon A/S, 2765 Smørum (DK)
(72) Inventor: Øllgaard, Mogens, 2765 Smørum (DK)
(74) Representative: William Demant

(56) References cited:
- EP-A1- 1 995 996
- WO-A1-98/58117
- WO-A1-2005/089961
- WO-A1-2008/053150
- WO-A1-2010/105829
- DE-A1- 3 627 151
- DE-C- 517 419
- US-A- 4 797 534
- HOWARD BECKER ET AL: "PTC Heating Elements---Background Analysis and Design Attributes", IEEE TRANSACTIONS ON INDUSTRY APPLICATIONS, IEEE SERVICE CENTER, PISCATAWAY, NJ, US, vol. IA-11, no. 4, 1 July 1985 (1985-07-01), pages 896-898, XP011265780, ISSN: 0093-9994
- YOUN H TING: "Self-Regulating PTC Heating Systems: A New Approach for Electric Heating Appliances", IEEE TRANSACTIONS ON INDUSTRY APPLICATIONS, IEEE SERVICE CENTER, PISCATAWAY, NJ, US, vol. IA-10, no. 3, 1 May 1972 (1972-05-01) , pages 338-344, XP011178530, ISSN: 0093-9994

## Description

### AREA OF THE INVENTION

The invention relates to the area of surface coating, and particularly of plasma enhanced surface coating whereby a monomer substance is caused to polymerize and settle onto surfaces forming a uniform layer of oil and water repellent material.

### BACKGROUND OF THE INVENTION

In such coating processes the monomer substance is to be introduced into an inert carrier gas and fed into a low pressure plasma chamber in a controlled amount. A uniform evaporation process whereby controlled amounts of monomer may be evaporated into a stream of inert gas is thus desired. Also a process and apparatus is desired, which may ensure high and uniform concentrations of monomer in the inert carrier gas in order that the coating process becomes efficient.

In WO 2008/053150 a method for coating a substrate with a polymerized compound comprising vaporized 1H, 1H, 2H, 2H-Perflourodecylacrulate in a low pressure plasma process. The document is moot as to how a constant concentration of the vaporized compound is provided.

In EP 1995996 a plasma induced coating system with an evaporator is disclosed.

### SUMMARY OF THE INVENTION

According to the invention a method for plasma coating at low pressure with a water and oil repellent polymer layer, is provided, whereby the method comprises the steps of:
- providing a substrate with a surface,
- vaporizing a compound comprising 1H, 1H, 2H, 2H-Perflourodecyl acrylate into a stream of inert gas,
- maintaining a constant temperature in the compound during the evaporation into the gas,
- exposing said surface to the mixture of gas and compound,
- exposing said surface to a continuous wave plasma generated in the gas and compound mixture, having a plasma power provided by a plasma circuit.

By ensuring constant temperature in the compound during evaporation, it is ensured that the amounts of monomer added to the gas stream remains constant over time.

The method further comprises the steps of:
- introducing the compound into a container and forming a liquid to gas interface in the container,
- introducing the stream of inert gas into the container above the liquid to gas interface,
- extracting the gas and vaporized compound mixture above the liquid to gas interface.

By introducing the compound into a container, a well defined liquid surface will be defined by the side walls of the container, and thus an evaporation surface of a predefined area is ensured, such that during evaporation even if the amount of liquid in the container changes, the same evaporation surface will be present. This requires the container to have cylindrically shaped walls, and that the amount of liquid covers a bottom part and submerges at least a lower part of the cylindrical wall parts. These dimensional measures are not difficult to meet. The method may be performed in various ways: possibly the evaporation may be continued until all introduced monomer liquid has been evaporated where after a new portion is dispensed, and this is repeated throughout the time of plasma coating, or possibly the dispensing of monomer into the container is performed continuously and regulated by the current drawn by the PTC elements such that it is ensured that at least the lowermost PTC elements has a portion thereof submerged in the monomer.

Preferably the stream of inert gas is heated to a predefined temperature prior to introducing in the container. This aids to ensure constant thermodynamic conditions in the evaporation zone, and also it helps to ensure, that the inert gas and monomer mixture has constant properties during the time of coating surface parts. Preferably the gas is heated to a temperature between 50 and 100 deg. celsius.

A constant voltage may be supplied to one or more resistive elements of the PTC type provided in the container. Thereby a constant temperature may be ensured during operation, as the PTC elements are self regulating in that if they are cooled, a higher current will flow through them which results in higher heat generation, and vice versa. In this way a self-regulating system is provided, which can ensure a stable temperature in the monomer evaporation zone.

When the monomer contacts a PTC element the temperature herein will fall resulting in an increased current as described, and if more PTC elements are present in the container and stacked one above the other, the upper elements may also be cooled by the stream of inert gas an monomer mixture flowing past them.

According to the method the current drain and/or resistance of the PTC elements is measured during vaporization, and a predetermined amount of liquid compound is introduced into the container when the current drain is below a predetermined threshold and/or the resistance of the PTC elements is above a predetermined threshold. In this way the PTC element also functions to monitor the presence of monomer in the evaporation area, and a separate gauge to monitor this may be omitted. Possibly a pause time between drying out of the monomer and adding a new portion may be introduced, in case this is beneficial to the process, and also a dry run period may be used when the coating process in the plasma chamber is coming to its final stage, as there by it may be ensured, that the evaporation container is completely empty, and no monomer is left in the container.

Preferably the PTC elements have a T_{NTT} or equilibrium temperature which is between 110 and 150 deg. celsius and most preferably the T_{NTT} is at 130 deg. celsius. This temperature is well above the boiling point of the liquid monomer compound, and hereby a stable evaporation rate is provided inside the container and through the presence of a number of PTC elements in the gas flow path away from the liquid surface, the inert gas and compound therein reach a stable state where no formation of condensate of the evaporated liquid is likely to take place. Thereby all evaporated liquid will reach the plasma processing chamber.

When the above measures are carried out, the plasma induced coating process becomes both stable, and as also a high concentration of monomer is ensured, without risk of the formation of condensate. The coating process may be carried out much speedier, and possibly the processing time may be reduced from about 40 minutes to about 7 minutes, whereby the plasma induced coating phase is reduced from 30 to 2.5 minutes, and at the same time producing a coat of polymerized monomer which is thicker than was previously obtained during 30 minutes of coating time.

It is intended that the structural features of the system described above and in the claims can be combined with the method, when appropriately substituted by a corresponding process. Embodiments of the method have the same advantages as the corresponding systems or apparatus.

Further objects of the invention are achieved by the embodiments defined in the dependent claims and in the detailed description of the invention.

As used herein, the singular forms "a," "an," and "the" are intended to include the plural forms as well (i.e. to have the meaning "at least one"), unless expressly stated otherwise. It will be further understood that the terms "includes," "comprises," "including," and/or "comprising," when used in this specification, specify the presence of stated features, integers, steps, operations, elements, and/or components, but do not preclude the presence or addition of one or more other features, integers, steps, operations, elements, components, and/or groups thereof. It will be understood that when an element is referred to as being "connected" or "coupled" to another element, it can be directly connected or coupled to the other element or intervening elements maybe present, unless expressly stated otherwise. Furthermore, "connected" or "coupled" as used herein may include wirelessly connected or coupled. As used herein, the term "and/or" includes any and all combinations of one or more of the associated listed items. The steps of any method disclosed herein do not have to be performed in the exact order disclosed, unless expressly stated otherwise.

### BRIEF DESCRIPTION OF THE DRAWINGS

Fig. 1 shows an evaporation container according to the invention along with a schematic representation of a dosing valve,
Fig. 2 shows a sectional view of the dosing valve,
Fig. 3 shows diagrammatic representation of a system which may be used to perform the invention,
Fig. 4 shows a generic diagram of the resistance versus temperature relationship for two different PTC elements,
Fig. 5 is a schematic presentation of a coating processing chamber which may be used in connection with the invention,
Fig. 6 shows a detail of the container in enlarged view.

The figures are schematic and simplified for clarity, and they just show details which are essential to the understanding of the invention, while other details are left out. Throughout, the same reference numerals are used for identical or corresponding parts.

Further scope of applicability of the present invention will become apparent from the detailed description given hereinafter. However, it should be understood that the detailed description and specific examples, while indicating preferred embodiments of the invention, are given by way of illustration only.

### DESCRIPTION OF A PREFERRED EMBODIMENT

An example of a method according to the invention is disclosed in the following. According to the method, plasma induced coating at low pressure with a water and oil repellent polymer layer is achieve through the steps cited in the following.

Initially a substrate with a surface to be coated is provided, and this could be any kind of substrate, notably electronic components, assemblies of electronic components, external and/or internal surface parts of devices to be used at or near the human body, such as medical devices comprising electronic or mechanic components. An example of such component may be audio devices such as hearing aids or headsets. The substrate is entered into a processing chamber and, as is well known in the art, the chamber is evacuated to a low pressure, and a pre-treatment process may initially be performed such as cleaning with oxygen plasma. Following this an inert gas comprising small amounts of the monomer compound in vapour form is introduced into the chamber and a plasma glow is ignited.

Evaporating controlled amounts of a suitable monomer compound such as 1H, 1H, 2H, 2H-Perflourodecyl acrylate into the stream of inert gas prior to the introduction into the chamber is performed by drawing the inert gas through a container 10 comprising a predetermined amount of the monomer compound in liquid condition.

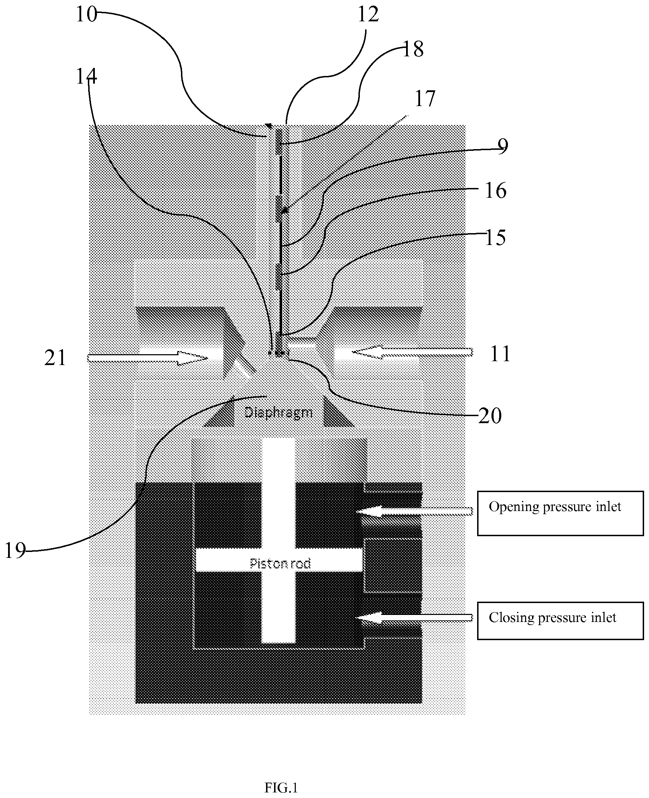

A constant flow of inert gas is caused to flow from a gas inlet 11 to an outlet 12 for the mixture of monomer and gas. As seen in fig. 1 the outlet is provided above the inlet 11 and the inlet 11 is itself provided above a bottom part of container 10. When a small amount of the liquid is introduced into container 10, a liquid to gas interface 14 or liquid surface will be provided below the gas inlet 11. A flow of inert gas will thereby pass above the liquid surface 14 and draw possible monomer vapour out of the container 10 through outlet 12.

A constant temperature in the liquid compound is maintained during the evaporation into the gas. This ensures constant evaporation rate, as evaporation from the surface 14 would otherwise cool down the liquid and thereby diminish evaporation. This tendency is counteracted by the heating the liquid and maintain constant temperature in the liquid during the evaporation.

Gas and monomer compound mixture is drawn into a plasma chamber, and the surfaces present her are exposed to the mixture of gas and compound during generation of a continuous wave plasma power. The plasma power is generated as is known in the art by a high frequency plasma generating electric circuitry, and is provided between electrode parts in the chamber.

Preferably the stream of inert gas is heated to a predefined temperature prior to being introduced in the container. In this way it is also ensured that the gas and evaporated compound mixture drawn out of the chamber 10 maintains constant properties over time.

The heating of the liquid compound is performed with a PTC element 15 which is connected to a constant electric power. The PTC 15 reach the curie or equilibrium temperature and the temperature stabilise around this temperature, as a further decrease in temperature will cause the resistance to fall dramatically resulting in a sharp rise in current through the PTC element which thereby heats up. As seen from fig. 1 a number of PTC thermistors 16, 17, 18 are provided inside the container 10 along the path which the gas must flow to reach the outlet 12. This ensures, that the vapour and gas mixture exits the container at a constant temperature.

After some time of evaporating monomer which could be around 2- 5 seconds, the monomer submerged portion at the lowermost PTC element will be free of monomer, and the temperature in this element and the above elements will rise gradually to the 130 deg C which is the equilibrium temperature. This may take around 15 seconds and now the current drawn by the PTC elements is at the same level as before dosing the monomer compound. The mentioned times here will be highly dependent on inert gas flow, curie or equilibrium temperature of the chosen PTC element and the amount and identity of the dispensed monomer.

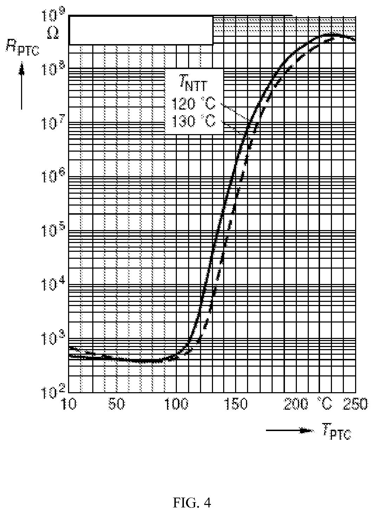

The relationship between temperature and ohmic resistance in a PTC element is shown in fig. 4. From the curves it can be seen that from 110 to 200 degrees C the resistance of the PTC element rises dramatically. If the PTC element is cooled down as a result of evaporating liquid, the fall in resistance will result in a strong rise in current consumption and thus heat generation. On the other hand, if the temperature of the element rises, the resistance increases and current flow will fall. At a predefined voltage supply, such as 40 volts, the PTC will have an equilibrium temperature of 130 deg C. If the PTC at this temperature is cooled down, such as by submerging parts thereof in a liquid with a boiling point below 130 degrees celsius, the evaporation due to boiling of the liquid will cause the PTC to cool down, resulting in increased current consumption. When all the liquid has been boiled off, the temperature will rise to 130 deg C and the current consumption will fall to a minimum. By monitoring the current consumption, it may then be determined whether any of the liquid compound is present at the PTC thermistor or not. Thus the current consumption/and or the resistance of the PTC element may be used as trigger addition of a new portion of liquid through the bottom inlet 20.

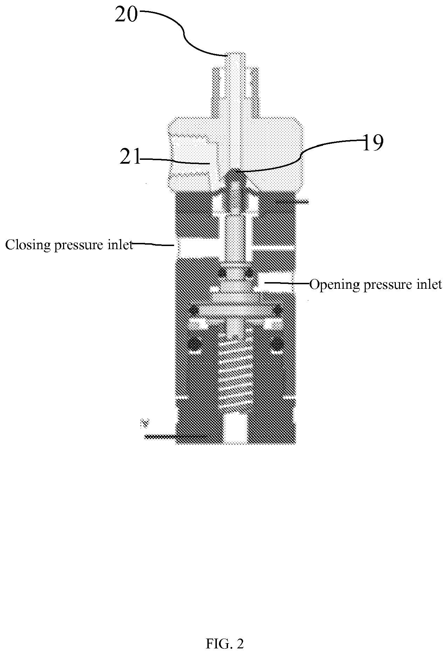

Control of liquid through inlet 20 is provided by valve 19. When the valve 19 opens, the liquid may flow from the liquid container (not shown) through monomer inlet 21 and into the container through the inlet 20. The valve 19 is controlled by compressed air as shown, which may supply pressure to the first or second side of a piston, which through piston rod opens or seals the valve 19. A schematic representation of the valve and air piston is given in Fig. 2. The valve is operated with compressed air, but electric or hydraulic operation would also be suitable.

The monomer/liquid will flow from a storage container (not shown) to the monomer inlet 20 of the evaporation container 10 due to the low pressure, when the valve 19, inserted in a tube leading from the storage container to the evaporation container, is opened.

Compressed air inlets for opening and closing the valve 19 are indicated in figs. 1 and 2.

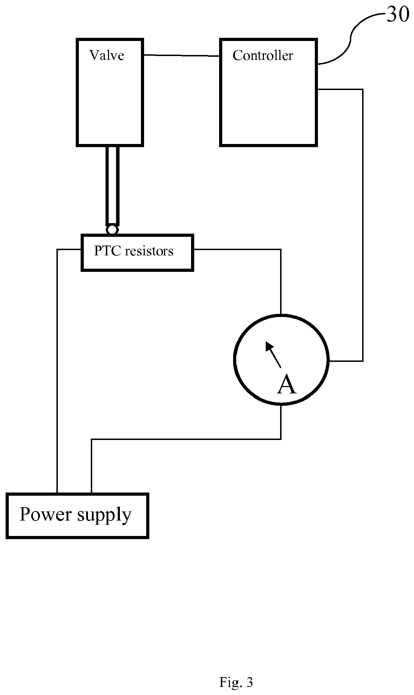

The valve opening time is timed to allow a predetermined amount of monomer liquid compound to enter into the container 10. This is achieved through a timed change of shifting pressure to the opening pressure inlet. This action is guided by controller 30 as indicated in fig. 3. The pull of the piston rod in the diaphragm valve 19 cause dispensing of a controlled amount of monomer onto the bottom of container 10 and the amount of liquid monomer will partially or fully submerge PTC thermistor 15.

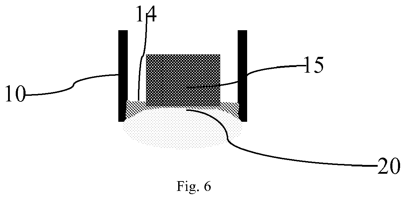

The lower part of the container 10 is shown in increased size in fig. 6. The PTC element or thermistor 15 has a lower edge thereof submerged below the liquid surface 14 of the monomer compound present in the container 10. The monomer inlet 20 is comprised of diaphragm valve 19. The container has a circular cylindrical shape with a diameter of 2.7mm providing an area of the liquid surface of 5.7mm². By way of this construction it is among others ensured that no monomer in liquid form will be carried out of the container 10, as the inlet for the inert gas is provided well above the monomer liquid surface 14. The amount of monomer dispensed in order to reach a situation as shown in fig. 6 is around 0.02g.

The liquid monomer cools the PTC thermistor and the electric current increase as mentioned above. The controller registers this increase as a confirmation that the liquid has actually entered the container. The high temperature on the PTC termistor heat up the monomer and the monomer evaporates. The feed gas moves the vapour out through the monomer vapour outlet 12.

When the monomer has evaporated and the vapor have left the container 10, the temperature on the PTC termistor reach the curie temperature and the electric current stabalise on the low electric curent level. This is registered by the controller 30 and a dwell time starts. When the dwell time has passed the process is repeated from the time of opening the valve 19.

When the predetermined number of dispenser cycles has reached the programmed number, the monomer evaporating stops and the controller send out a signal that the process is complete. This will usually be at the same time as coating in the coating chamber is expected to have reached its conclusion with a thin and even coat of polymerized parts of the monomer being settled on the surfaces present in the coating chamber.

In case the monomer does not cool the PTC thermistor the controller send out an alarm signal. The monomer container is believed to be empty, and possibly an operator will have to intervene.

Voltage is supplied to one or more resistive elements 15, 16, 17, 18 of the PTC type provided in the container 10. Only one of the elements 15 are actually submerged in the liquid, where the PTC elements 16, 17, 18 are provided in the flow path of the monomer and gas mixture and they ensure, that the right temperature is obtained prior to the exit of the gas through exit 12.

Preferably the PTC elements have a T_{NTT} or equilibrium temperature which is between 110 and 150 deg. Celsius and most preferably the T_{NTT} is at 130 deg. celsius.

The PTC resistors may be connected in series or in parallel and suspended from electrical conductors 9. The conductors 9 are connected to a power source outside the container. In the present embodiment the resistive elements are connected in parallel.

Possibly the control electronics comprise a programmable computer device, a PLC or the like adapted to control the power source, the valve controlling the supply of monomer compound into the chamber, and the valves controlling the flow of inert gas through the container 10.

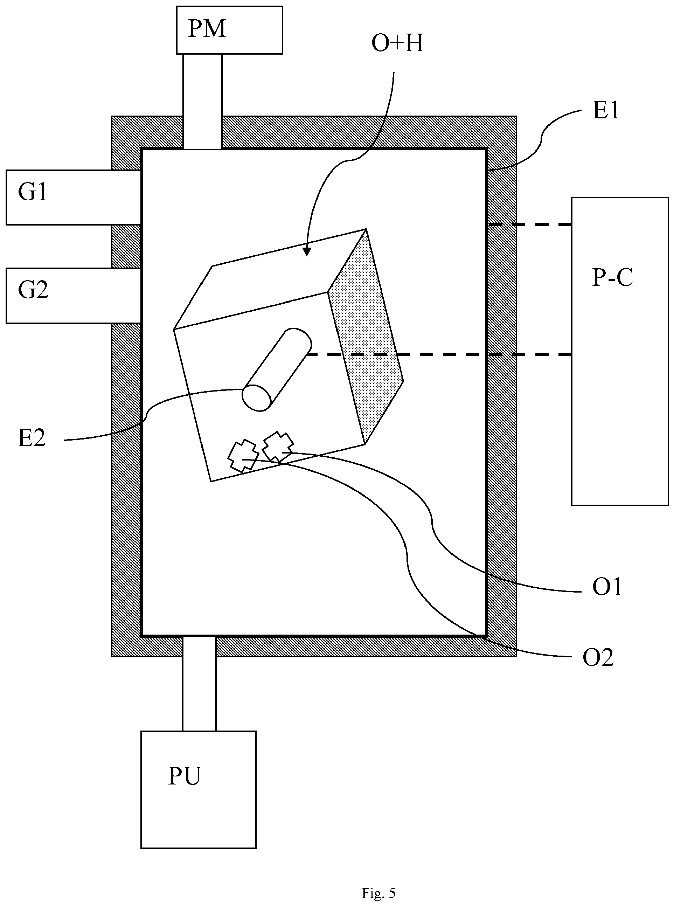

In Fig. 5 the equipment used for carrying out the plasma polymerization process according to the invention is diagrammatically illustrated. A plasma chamber PLC is provided that can be at least partly evacuated by means of a pump PU. By means of the pump PU, a low pressure gas atmosphere with a gas pressure between 5 and 70 Pa can be created in the plasma chamber PLC. After evacuation a controlled gas flow may be provided to the chamber by pump PM. The gas could be oxygen taken from an oxygen tank (not shown) and not passing through container 10, in case a cleaning plasma operation is to be performed, or an inert gas such as argon in case a plasma induced polymerization is desired and in this case at least part of this gas flow may be drawn through the container 10.

Two electrodes E1 and E2 are arranged within the plasma chamber PLC. In the presented embodiment the one electrode E1 is an internal metal wall of the chamber PLC. Between the electrodes E1 and E2, an object holder O+H. is arranged. The object holder O+H is comprised of an open box-like structure, which may be rotated about an axis such that objects inside the box are freely tumbled when the box is rotated. Possibly the box may be made of a transparent and electrically isolating material such as glass or plastic. The further electrode E2 is fixed inside the object holder O+H. The plasma circuit P-C is arranged outside the plasma chamber PLC. One terminal of the plasma circuit P-C is connected to the electrode E1 and the other terminal to the electrode E2 as indicated with dashed lines. Alternatively the box is made of metal such as steel, and in this case the box may serve as the one electrode. In such an embodiment the box should comprise a transparent window, such that the operator may actually see the faint glow of the plasma herein.

The plasma circuit comprises a radio frequency generator and, optionally, an impedance matching circuit, also referred to as an L-C circuit because the impedance matching circuit typically comprises a capacitor C and an inductor L. By means of the impedance matching circuit, the output impedance of the generator of the plasma circuit P-C can be matched to the input impedance of the plasma chamber PLC.

In order to perform a plasma polymerization process, the monomer is to be fed to the interior of the plasma chamber PLC. For this purpose, a monomer supply is provided in connection with pump PM, such that a monomer vapour may be added to the flow of gas provided to the chamber PLC. This is achieved as described above by way of the container 10 and polymer evaporation arrangement.

In order to monitor the gas pressure in the plasma chamber, pressure gauges G1 and G2 are provided.

For performing a plasma polymerization process, a substrate (that is objects O1, O2 to be surface coated) are placed in the object holder O+H. Any number of objects, which fits inside the object holder and may be tumbled therein to expose all surfaces to the plasma, may be placed in the object holder. The interior of the plasma chamber PLC as well as the object holder are evacuated by means of pump PU. As the interior of the object holder O+H is in open fluid connection with the chamber PLC the same pressure and other physical condition will be present inside the object holder box. A monomer, in particular 1H, 1H, 2H, 2H-perfluorodecyl acrylate, is fed to the interior of the plasma chamber PLC by means of monomer pump PM. A high-voltage radio frequency electric power is applied between the electrodes E1 and E2 by means of the plasma circuit P-C. An initial high plasma power is reduced within a time period of 5 second to 10 minutes to a final lower plasma power. The higher plasma power (power necessary to ignite the plasma condition of the gas), is used initially in order to cause ignition of the plasma. By the subsequent lowering of the plasma power, an even polymer layer on the substrate (object) to be coated is achieved.

The above steps are the basic steps required to perform coating with the plasma polymerization process, and in use they will be performed as described, however, further steps may be performed, such as plasma cleaning steps, steps for flushing the chamber and the like which are introduced when necessary or beneficial. Such additional steps are well known by the skilled artisan and are not described in any further detail.

## Claims

1. Method for plasma coating at low pressure with a water and oil repellent polymer layer, the method comprising the steps of:
- providing a substrate (O1, O2) with a surface,
- vaporizing a compound comprising 1H, 1H, 2H, 2H-Perfluorodecyl acrylate into a stream of inert gas,
- maintaining a constant temperature in the compound during the evaporation into the gas,
- exposing said surface to the mixture of gas and compound,
- exposing said surface to a continuous plasma generated in the gas and compound mixture, having a plasma power provided by a plasma circuit,
- introducing the compound into a container (10) and forming a liquid to gas interface (14) in the container (10),
- introducing the stream of inert gas into the container (10) above the liquid to gas interface (14),
- extracting the gas and vaporized compound mixture above the liquid to gas interface (14),
- defining the liquid surface (14) by cylindrically shaped side walls of the container (10), and thus ensuring an evaporation surface of a predefined area, such that during evaporation even if the amount of liquid in the container (10) changes, the same evaporation surface will be present, and
- providing an amount of liquid, which covers a bottom part and submerges at least a lower part of the cylindrical wall parts,
- supply a constant voltage to one or more resistive elements (15,16,17,18) of the PTC type provided in the container along the path which the gas must flow to reach an outlet (12) of the container (10) wherein one heating element (15) has a lower edge thereof submerged below the liquid surface (14) and in contact with the liquid compound present in the container (10).

2. Method as claimed in claim 1, wherein further the stream of inert gas is heated to a predefined temperature prior to introducing the gas in the container (10)

3. Method as claimed in claim 2, comprising the following further steps:
- measuring the current drain and/or resistance of the PTC elements during evaporization,
- introducing a predetermined amount of liquid compound into the chamber when the current drain is below a predetermined threshold and/or the resistance of the PTC elements is above a predetermined threshold.

4. Method as claimed in claim 3, whereby the PTC elements (15,16,17,18) has a T_{NTT} or equilibrium temperature which is between 110 and 150 deg. celsius and most preferably the T_{NTT} is at 130 deg. celsius.

5. Apparatus for coating a surface with a plasma induced polymer layer generated from a compound comprising liquid 1H, 1H, 2H, 2H-Perfluorodecyl acrylate, whereby the apparatus comprises a low pressure plasma chamber (PLC) and an evaporator and a supply system for feeding a stream of inert gas with an amount of the compound therein into the plasma chamber, the evaporator comprising a container (10) with an amount of the liquid 1H, 1H, 2H, 2H-Perfluorodecyl acrylate therein defining a compound to inert gas interface (14) whereby a stream of inert gas may be supplied to the container through an inlet (11) into the container (10) provided above the interface (14) and that inert gas may be drawn from the container from an outlet (12) provided above the interface (14), whereby the liquid surface (14) is defined by cylindrically shaped side walls of the container (10), and thus ensures an evaporation surface of a predefined area, such that during evaporation even if the amount of liquid in the container (10) changes, the same evaporation surface will be present, and wherein a heating element (15) is provided below the interface (14) and in contact with the liquid compound and wherein further heating elements (16,17,18) are provided in the container (10) between the gas inlet (11) and the outlet(12) in the path which the gas must flow to reach the outlet (12) of the container (10).

6. Apparatus as claimed in claim 5, wherein the heating element (15,16,17,18) comprises at least one PTC resistor with a T_{NTT} temperature.

7. Apparatus as claimed in claim 6, wherein a number of PTC resistors are provided inside the container (10), electrically connected in parallel, and suspended from electrical conductors (9) connected to a power source outside the container.

8. Apparatus as claimed in claim 7, wherein control electronics such as a programmable computer device, a PLC or the like adapted to control the power source and a valve (19) controlling the supply of monomer compound into the chamber (10), and valves controlling the flow of inert gas through the container.

## Patentansprüche

1. Verfahren zur Plasmabeschichtung bei geringem Druck mit einer wasser- und ölabweisenden Polymerschicht, wobei das Verfahren die Schritte aufweist:
- Bereitstellen eines Substrats (O1, O2) mit einer Oberfläche,
- Verdampfen einer Komponente, die 1H, 1H, 2H, 2H-Perfluordecylacrylat aufweist, in einen Strom aus inertem Gas,
- Aufrechterhalten einer konstanten Temperatur in der Komponente während des Verdampfens in das Gas,
- Aussetzen der Oberfläche der Mischung aus dem Gas und der Komponente,
- Aussetzen der Oberfläche einem kontinuierlichen Plasma, das in der Gas-und-Komponenten-Mischung erzeugt wurde, mit einer durch einen Plasmakreislauf bereitgestellten Plasmaleistung,
- Einleiten der Komponente in einen Behälter (10) und Bilden einer Flüssig-Gas-Grenzfläche (14) in dem Behälter (10),
- Einführen des Stroms aus inertem Gas in den Behälter (10) über der Flüssig-Gas-Grenzfläche (14),
- Entnehmen der Gas-und-verdampfte-Komponenten-Mischung über der FlüssigGas-Grenzfläche (14),
- Festlegen der Flüssigkeitsoberfläche (14) durch zylindrisch geformte Seitenwände des Behälters (10) und dadurch Sicherstellen einer Verdampfungsoberfläche mit einer vorbestimmten Fläche, derart, dass während des Verdampfens, selbst wenn sich die Flüssigkeitsmenge in dem Behälter (10) verändert, die gleiche Verdampfungsoberfläche vorliegt, und
- Bereitstellen einer Flüssigkeitsmenge, die einen Bodenbereich überdeckt und mindestens einen unteren Bereich der zylindrischen Wandteile eintauchen lässt,
- Versorgen von einem oder mehreren Widerstands-Elementen (15, 16, 17, 18) des PTC-Typs, die in dem Behälter entlang desjenigen Pfades bereitgestellt sind, den das Gas zum Erreichen eines Auslasses (12) des Behälters (10) fließen muss, mit einer konstanten Spannung, wobei ein Heizelemente (15) eine untere Kante hat, die unter die Flüssigkeitsoberfläche (14) eintaucht und in Kontakt mit der flüssigen in dem Behälter (10) vorliegenden Komponente ist.

2. Verfahren wie in Anspruch 1 beansprucht, wobei während eines weiteren der Strom aus inertem Gas auf eine vorbestimmte Temperatur erhitzt wird, bevor das Gas in den Behälter (10) eingeführt wird.

3. Verfahren wie in Anspruch 2 beansprucht, mit den folgenden weiteren Schritten:
- Messen des Stromverbrauchs und/oder Widerstands der PTC-Elemente während des Verdampfens,
- Einführen einer vorbestimmten Menge der flüssigen Komponente in die Kammer, falls der Stromverbrauch unter einer vorbestimmten Schwelle und/oder der Widerstand der PTC-Elemente über einer vorbestimmten Schwelle ist.

4. Verfahren wie Anspruch 3 beansprucht, wobei die PTC-Elemente (15, 16, 17, 18) eine T_{NTT} oder Gleichgewichtstemperatur haben, die zwischen 110 und 150 Grad Celsius liegt und wobei besonders bevorzugt die T_{NTT} bei 130 Grad Celsius liegt.

5. Vorrichtung zum Beschichten einer Oberfläche mit einer plasmainduzierten Polymerschicht, die aus einer Komponente erzeugt wurde, die flüssiges 1H, 1H, 2H, 2H-Perfluordecylacrylat aufweist, wobei die Vorrichtung eine Niederdruckplasmakammer (PLC) und einen Verdampfer und ein Versorgungsystem zum Zuführen eines Stroms aus inertem Gas mit einer Menge der Komponente darin in die Plasmakammer aufweist, wobei der Verdampfer einen Behälter (10) mit einer Menge von dem flüssigen 1 H, 1 H, 2H, 2H-Perfluordecylacrylat darin aufweist, die eine Komponente-zu-inertem-Gas-Grenzfläche (14) festlegt, wobei ein Strom aus inertem Gas dem Behälter durch einen Einlass (11) in dem Behälter (10) zugeführt werden kann, der über der Grenzfläche (14) bereitgestellt ist und dass das inerte Gas dem Behälter aus einem Auslass (12), der über der Grenzfläche (14) bereitgestellt ist, entnommen werden kann, wobei die Flüssigkeitsoberfläche (14) durch zylindrisch geformte Seitenwände des Behälters (10) festgelegt ist, und somit eine Verdampfungsoberfläche mit einer vorbestimmten Fläche sicherstellt, so dass während des Verdampfens, selbst wenn sich die Flüssigkeitsmenge in dem Behälter (10) verändert, die gleiche Verdampfungsoberfläche vorliegt, und wobei ein Heizelement (15) unter der Grenzfläche (14) bereitgestellt und in Kontakt mit der flüssigen Komponente ist und wobei weitere Heizelemente (16, 17, 18) in dem Behälter (10) zwischen dem Gaseinlass (11) und dem Auslass (12) in dem Pfad, den das Gas zum Erreichen des Auslasses (12) des Behälters (10) fließen muss, bereitgestellt sind.

6. Vorrichtung wie in Anspruch 5 beansprucht, wobei das Heizelement (15, 16, 17, 18) mindestens einen PTC-Widerstand mit einer T_{NTT} Temperatur aufweist.

7. Vorrichtung wie in Anspruch 6 beansprucht, wobei eine Anzahl von PTC-Widerständen in dem Behälter (10) bereitgestellt sind, die elektrisch parallel geschaltet sind und von elektrischen Leitern (9) getragen werden, die mit einer Stromquelle außerhalb des Behälters verbunden sind.

8. Vorrichtung wie in Anspruch 7 beansprucht, wobei die Steuerelektronik, wie etwa ein programmierbares Computergerät, ein PCL oder dergleichen ausgebildet sind, die Stromquelle und ein Ventil (19), das die Zufuhr von Monomerkomponenten in den Behälter (10) steuert, zu steuern und wobei Ventile den Strom aus inertem Gas durch den Behälter steuern.

## Revendications

1. Procédé de revêtement par plasma à basse pression avec une couche de polymère hydro et oléo répulsive, le procédé comprenant les étapes de :
- fourniture d'un substrat (O1, O2) avec une surface,
- vaporisation d'un composé comprenant le 1H, 1H, 2H, 2H-perfluorodécyl acrylate dans un flux de gaz inerte,
- maintien d'une température constante dans le composé pendant l'évaporation dans le gaz,
- exposition de ladite surface au mélange de gaz et de composé,
- exposition de ladite surface à un plasma continu généré dans le mélange de gaz et de composé, ayant une puissance de plasma fournie par un circuit de plasma,
- introduction du composé dans un récipient (10) et formation d'une interface liquide-gaz (14) dans le récipient (10),
- introduction du flux de gaz inerte dans le récipient (10) au-dessus de l'interface liquide-gaz (14),
- extraction du mélange de gaz et de composé vaporisé au-dessus de l'interface liquide-gaz (14),
- délimitation de la surface du liquide (14) par des parois latérales de forme cylindrique du récipient (10), et garantir ainsi une surface d'évaporation d'une zone prédéfinie, de sorte que, pendant l'évaporation, même si la quantité de liquide dans le récipient (10) change, la même surface d'évaporation sera présente, et
- fourniture d'une quantité de liquide, qui recouvre une partie basse et qui submerge au moins une partie inférieure des parties de parois cylindriques,
- alimentation d'une tension constante d'un ou plusieurs éléments résistifs (12, 16, 17, 18) de type PTC prévus dans le récipient le long du passage que le gaz doit parcourir pour atteindre une sortie (12) du récipient (10) où un élément chauffant (15) comprend un bord inférieur de celui-ci immergé sous la surface du liquide (14) et en contact avec le composé liquide présent dans le récipient (10).

2. Procédé selon la revendication 1, où en outre le flux de gaz inerte est chauffé à une température prédéfinie avant l'introduction du gaz dans le récipient (10).

3. Procédé selon la revendication 2, comprenant les étapes suivantes :
- la mesure de la consommation de courant et/ou de la résistance des éléments PTC pendant l'évaporation,
- l'introduction d'une quantité prédéterminée de composé liquide dans la chambre lorsque la consommation de courant est inférieure à un seuil prédéterminé et/ou la résistance des éléments PTC est au-dessus d'un seuil prédéterminé.

4. Procédé selon la revendication 3, où les éléments PTC (15, 16, 17, 18) présentent une T_{NTT} ou température d'équilibre qui est entre 110 et 150 deg. Celsius et plus préférentiellement la T_{NTT} est à 130 deg. Celsius.

5. Appareil pour revêtement d'une surface avec une couche de polymère induit par un plasma généré à partir d'un composé comprenant du 1H, 1H, 2H, 2H-perfluorodécyl acrylate liquide, où l'appareil comprend une chambre de plasma basse pression (PLC) et un évaporateur et un système d'alimentation pour alimenter un flux de gaz inerte avec une quantité du composé à l'intérieur de la chambre de plasma, l'évaporateur comprenant un récipient (10) avec une quantité du 1H, 1H, 2H, 2H-perfluorodécyl acrylate liquide délimitant une interface composé-gaz inerte (14), où un flux de gaz inerte peut être fourni au récipient à travers une entrée (11) dans le récipient (10) prévue au-dessus de l'interface (14) et que le gaz inerte peut être retiré du récipient à partir d'une sortie (12) prévue au-dessus de l'interface (14), où la surface liquide (14) est délimitée par des parois latérales de forme cylindrique du récipient (10), et garantie ainsi une surface d'évaporation d'une zone prédéfinie, de sorte que, pendant l'évaporation, même si la quantité de liquide dans le récipient (10) change, la même surface d'évaporation sera présente, et où un élément chauffant (15) est prévu sous l'interface (14) et en contact avec le composé liquide et où d'autres éléments chauffants (16, 17, 18) sont prévus dans le récipient (10) entre l'entrée (11) et la sortie (12) du gaz dans le passage que le gaz doit parcourir pour atteindre la sortie (12) du récipient (10).

6. Appareil selon la revendication 5, **caractérisé en ce que** l'élément chauffant (15, 16, 17, 18) comprend au moins une résistance PTC avec une température T_{NTT}.

7. Appareil selon la revendication 6, où un certain nombre de résistances PTC sont prévues à l'intérieur du récipient (10), connectés électriquement en parallèle, et suspendus à des conducteurs électriques (9) connectés à une source d'alimentation à l'extérieur du récipient.

8. Appareil selon la revendication 7, ou une électronique de contrôle comprend un dispositif informatique programmable, un PLC ou analogue adapté pour contrôler la source d'alimentation et une vanne (19) contrôlant l'alimentation en composé monomère dans la chambre (10), et des vannes contrôlant l'écoulement de gaz inerte à travers le récipient.
